(19)

**Europäisches Patentamt**
**European Patent Office**
**Office européen des brevets**

(11)  **EP 4 632 411 A1**

(12)  **EUROPEAN PATENT APPLICATION**

(43) Date of publication:
**15.10.2025  Bulletin 2025/42**

(21) Application number: **24305592.8**

(22) Date of filing: **12.04.2024**

(51) International Patent Classification (IPC):
**G01R 31/392** (2019.01)     **G01R 31/396** (2019.01)

(52) Cooperative Patent Classification (CPC):
**G01R 31/392; G01R 31/396;** G01R 31/52

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP USA, Inc.
Austin TX 78735 (US)**

(72) Inventors:
• **Prochazka, Wenzel
  5656 AG Eindhoven (NL)**

• **Kofler, Robert
  5656 AG Eindhoven (NL)**
• **Cassagnes, Thierry Dominique Yves
  31023 Toulouse Cedex 1 (FR)**
• **Mallard, Thomas
  31023 Toulouse Cedex 1 (FR)**
• **d'Esposito, Francesco
  31023 Toulouse Cedex 1 (FR)**

(74) Representative: **Schmütz, Christian Klaus
  Johannes
  NXP Semiconductors Germany GmbH
  Intellectual Property Group
  Beiersdorfstr. 12
  22529 Hamburg (DE)**

(54)  **A MONITORING CIRCUIT FOR A BATTERY CELL**

(57)     A monitoring circuit for a battery cell, the monitoring circuit comprising: a sigma-delta modulator, configured to receive an analog cell voltage signal and output a digital cell voltage signal; a first decimation filter configured to receive the digital cell voltage signal and down-sample the digital cell voltage at a first down-sampling rate to output a first down-sampled cell voltage signal; a second decimation filter configured to receive the digital cell voltage signal and down-sample the digital cell voltage at a second down-sampling rate, different to the first down-sampling rate, to output a second down-sampled cell voltage signal; and a difference module configured to receive the first down-sampled cell voltage signal and the second down-sampled cell voltage signal and output a cell monitoring signal based on a difference between the first down-sampled cell voltage signal and the second down-sampled cell voltage signal.

FIG. 2

Processed by Luminess, 75001 PARIS (FR)

# Description

## Field

The present disclosure relates to a monitoring circuit for a battery cell, a monitoring system for a plurality of battery cells and a battery management system.

## Background

Battery cells such as, Lithium-Ion cells, experience deterioration over their lifetime on their electrode surfaces. The electrode surfaces can become more fragmented and "micro-dendrites" can grow from an electrode through the separator. Eventually these micro-dendrites can grow through the separator to the other electrode and cause a micro-short-circuit (MSC) between the two electrodes. These micro-dendrites and micro-shorts-circuits do not usually result in instant catastrophic failure, but as the micro-dendrite melts away due to the current from the MSC, spots of molten or pierced separator remain. The interval between MSCs shortens (more often per time period) towards the end of life of a cell, and also in the build-up of a catastrophic failure.

The MSCs result in very short, low amplitude current spikes that are typically filtered out by noise control. Detection of MSCs and their corresponding current spike is typically performed in software using the SoX (state of parameter X (state of charge, state of energy, state of health etc.)) algorithm of a battery management system (BMS), via complicated search algorithms and requiring high speed processing.

## Summary

According to a first aspect of the present disclosure there is provided a monitoring circuit for a battery cell, the monitoring circuit comprising:

> a sigma-delta modulator, configured to receive an analog cell voltage signal and output a digital cell voltage signal;
> a first decimation filter configured to receive the digital cell voltage signal and down-sample the digital cell voltage signal at a first down-sampling rate to output a first down-sampled cell voltage signal;
> a second decimation filter configured to receive the digital cell voltage signal and down-sample the digital cell voltage signal at a second down-sampling rate, different to the first down-sampling rate, to output a second down-sampled cell voltage signal; and
> a difference module configured to receive the first down-sampled cell voltage signal and the second down-sampled cell voltage signal and output a cell monitoring signal based on a difference between the first down-sampled cell voltage signal and the second down-sampled cell voltage signal.

The monitoring circuit according to the first aspect can advantageously provide a hardware solution for detecting micro-short-circuits in a battery cell and avoid the high-speed and processing requirements of conventional BMS software solutions for detecting spikes corresponding to micro-short-circuits.

In one or more embodiments, the second down-sampling rate may be less than the first down-sampling rate.

In one or more embodiments, the first down-sampling rate may be equal to an oversampling rate of the sigma-delta modulator.

In one or more embodiments, the monitoring circuit may comprise a scaling circuit configured to scale the first down-sampled cell voltage to have the same resolution as the second down-sampled cell voltage.

In one or more embodiments, the monitoring circuit may be configured to detect a micro-short-circuit in the battery cell if an amplitude of the cell monitoring signal exceeds a threshold value.

In one or more embodiments, the sigma delta modulator and the first decimator may form an analog to digital conversion circuit. The monitoring circuit may be configured to output the first down-sampled-cell-voltage signal to a battery management system for voltage measurement.

According to a second aspect of the present disclosure there is provided a monitoring system for a plurality of battery cells connected in series, the monitoring system comprising a plurality of any of the monitoring circuits disclosed herein. Each monitoring circuit may correspond to one of the plurality of battery cells and may be configured to output a respective cell monitoring signal. The monitoring system may comprise processing logic configured to detect a micro-short-circuit in one of the plurality of battery cells based on difference signals corresponding to differences between the cell monitoring signals of adjacent battery cells of the plurality of battery cells.

In one or more embodiments, the processing logic may be configured to determine a difference signal between the respective cell monitoring signals of each neighbouring pair of battery cells of the plurality of battery cells.

In one or more embodiments, the processing logic may be configured to:

> for each battery cell, determine one or two difference signals, each difference signal corresponding to a difference between:
>
>> the cell monitoring signal corresponding to the battery cell; and
>> a cell monitoring signal corresponding to a neighbouring battery cell adjacent to the battery cell; and
>
> detect a micro-short-circuit in one of the plurality of battery cells based on the difference signals.

In one or more embodiments, the processing logic may be configured to:

compare an amplitude of each difference signal to a threshold value; and
detect a micro-short-circuit in one of the plurality of battery cells if the amplitude of each difference signal associated with that battery cell exceeds the threshold value.

In one or more embodiments, the processing logic may be configured to detect a micro-short-circuit in one of the plurality of battery cells if:

the amplitude of each difference signal associated with that battery cell exceeds the threshold value; and
the amplitude of each of the remaining difference signals does not exceed the threshold value.

In one or more embodiments, the processing logic may detect a micro-short-circuit in one of the plurality of battery cells, if the amplitude of each difference signal, determined based on a difference between the cell monitoring signal corresponding to that battery cell and a cell monitoring signal corresponding to an adjacent battery cell, exceeds the threshold value, and the amplitude of each remaining difference signal does not exceed the threshold value.

In one or more embodiments, the processing logic may comprise a plurality of comparators. Each comparator may be configured to receive a respective difference signal, compare an amplitude of the difference signal against the threshold value and output a logic signal representative of whether the amplitude of the difference signal exceeds the threshold value.

In one or more embodiments, the processing logic may comprise a plurality of AND gates. Each AND gate may correspond to a respective battery cell and each AND gate may be configured to receive:

each logic signals associated with the respective battery cell;
inverted versions of each remaining logic signal.

In one or more embodiments, the processing logic may be configured to output one or more parameter output signals comprising one or more of:

a cell flag signal indicating detection of a spike corresponding to a micro-short-circuit, for each battery cell.
an amplitude of a last detected spike, for all battery cells and/or for each battery cell;
a maximum amplitude over time of the detected spikes, for all battery cells and/or for each battery cell;
a time duration of the last detected spike, for all battery cells and/or for each battery cell;
a maximum time duration over time of the detected spikes, for all battery cells and/or for each battery cell; and
a total number of detected spikes over time, for all battery cells and/or for each battery cell.

In one or more embodiments, the monitoring system may comprise one or more registers for storing a parameter state corresponding to a respective parameter output signal.
According to a third aspect of the present disclosure there is provided a battery management system comprising any of the battery monitoring circuits or any of the monitoring systems disclosed herein.
In one or more embodiments, the battery management system may be configured to determine one or more of:

a cell state of each of the plurality of battery cells based on the one or more parameter output signals; and
a functional safety state of the battery management system based on the one or more parameter output signals.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.
The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

**Brief Description of the Drawings**

One or more embodiments will now be described by way of example only with reference to the accompanying drawings in which:

Figure 1 illustrates a monitoring circuit for a battery cell according to an embodiment of the present disclosure;
Figure 2 illustrates a second example monitoring circuit according to an embodiment of the present disclosure;

Figure 3A illustrates an example simulated cell monitoring signal of a monitoring circuit according to an embodiment of the present disclosure;

Figure 3B illustrates simulated noise effects on an example cell monitoring signal of a monitoring circuit according to an embodiment of the present disclosure;

Figure 4 schematically illustrates noise effects in a cell voltage signal;

Figure 5 illustrates a monitoring system for detecting a current spike arising from a micro-short-circuit in one of a plurality of battery cells connected in series according to an embodiment of the present disclosure;

Figure 6 illustrates a simulated difference signal calculated as the difference between two noisy cell monitoring signals;

Figure 7A illustrates simulated spikes in a cell voltage signal, a corresponding difference signal and a corresponding cell flag signal;

Figure 7B illustrates a counter signal corresponding to the signals of Figure 7A;

Figure 7C illustrates an amplitude of last detected spike signal corresponding to the signals of Figure 7A; and

Figure 7D illustrates a duration of last detected spike signal corresponding to the signals of Figure 7A.

## Detailed Description

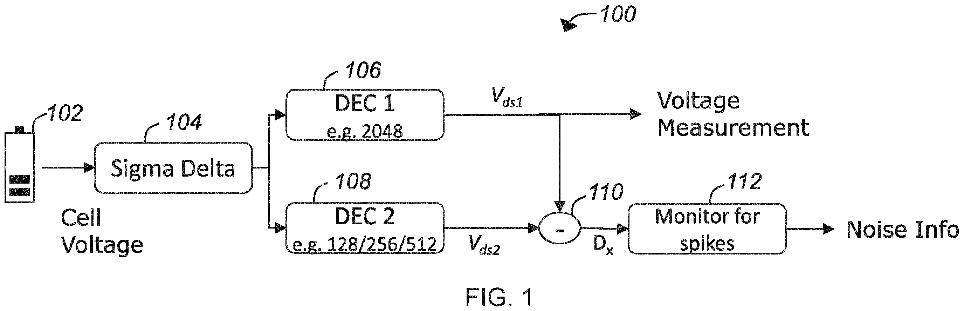

Figure 1 illustrates a monitoring circuit 100 for a battery cell 102 according to an embodiment of the present disclosure. The monitoring circuit 100 comprises a sigma-delta modulator 104 (which may also be referred to as a delta-sigma modulator and may simply be referred to as a sigma-delta or delta-sigma in the present disclosure). The sigma-delta 104 receives an analog cell voltage signal from the battery cell 102 and outputs a digital cell voltage signal. The monitoring circuit 100 includes a first decimation filter 106 that receives the digital cell voltage signal from the sigma-delta 104 and down-samples the digital cell voltage signal at a first down-sampling rate (2048 in this example) to output a first down-sampled cell voltage signal, $V_{ds1}$. The monitoring circuit 100 includes a second decimation filter 108 that receives the digital cell voltage signal from the sigma-delta 104 and down-samples the digital cell voltage at a second down-sampling rate (128, 256 or 512 in this example), that is different to the first down-sampling rate, to output a second down-sampled cell voltage signal, $V_{ds2}$. The monitoring circuit 100 also includes a difference module 110 configured to receive the first down-sampled cell voltage signal, $V_{ds1}$, and the second down-sampled cell voltage signal, $V_{ds2}$, and output a cell monitoring signal, $D_x$, based on a difference between the first down-sampled cell voltage, $V_{ds1}$, and the second down-sampled cell voltage, $V_{ds2}$.

The cell monitoring circuit 100 may form part of the cell management controller (CMC) that is a hardware part of the BMS that is mounted directly at the battery cell for measuring voltage temperature etc. The CMC can output data (voltage measurement and cell monitoring signal) to the battery management unit (BMU) of the BMS for further processing.

The cell monitoring signal, $Dx$, can be monitored for a spike corresponding to a micro-short-circuit (MSC). As referred to herein, a MSC is a short circuit that occurs between the electrodes of a battery cell due to dendrite formation. In some examples, the monitoring circuit 100 may perform spike detection on the cell monitoring signal, $Dx$. In this example, the monitoring circuit 100 comprises processing logic 112 for monitoring the cell monitoring signal, $D_x$, for spikes. As described further below, the processing logic 112 may receive one or more cell monitoring signals, $D_x$, corresponding to other battery cells, wherein the other battery cells and the battery cell 102 form a string of battery cells. The processing logic 112 may also output noise information, relating to noise common to each cell, to the BMU. In some examples, downstream circuitry, such as the BMU, may perform the spike detection on the cell monitoring signal.

The monitoring circuit 100 advantageously provides a hardware solution for detecting MSCs in a battery cell that can avoid the high-speed and processing requirements of conventional BMS software solutions for detecting spikes corresponding to MSCs.

Furthermore, the cell monitoring circuit 100 can make use of existing hardware that is already present in battery monitoring circuits. For example, a typical analog to digital converter (ADC) in a CMC can include a sigma-delta 104 and one decimation filter 106 to provide a digital cell voltage measurement signal that can be output to the BMU for voltage measurement purposes. In this way, the present cell monitoring circuit can provide for cell health and defect identification using an extended version of the existing A/D conversion circuit in a conventional BMS.

The cell 102 may comprise any type of battery cell including cells with intercalation chemistry, such as Lithium-ion and Sodium-ion based cells, and cells with surface chemistry such as lead acid cells.

The sigma-delta 104 can process the analog cell voltage signal at a clock frequency that is an integer multiple (an over-sampling rate (OSR)) of the desired digital cell voltage measurement signal. In this way, the sigma-delta 104 can oversample the analog cell voltage signal at the OSR to output an oversampled digital cell voltage signal. Correspondingly, the first decimation filter 106 may down-sample the oversampled digital cell voltage signal at a first down-sampling rate equal to the OSR to output the first down-sampled cell voltage signal as the digital cell voltage measurement signal. This approach of oversampling with the sigma delta 104 and down-sampling via a single decimation filter is a known ADC approach, with associated advantages in relation to resolution, and is not discussed further here.

Example monitoring circuits of the present disclosure include the second decimation filter 108, with a second down-sampling rate that is different to the first down-sampling rate, and the difference module 110 for outputting the cell monitoring signal, $D_x$, based on the difference between the first down-sampled cell voltage signal, $V_{ds1}$, and the second down-sampled cell voltage signal $V_{ds2}$.

The down-sampling / decimation process of the first decimation filter 106 may smooth or average out any current spikes corresponding to MSCs. Therefore, the second down-sampling rate may be less than the first down-sampling rate in order to preserve the current spike information. In some examples, the first down-sampling rate may be equal to an OSR of the sigma-delta 104 and the second down-sampling rate may be less than the first down-sampling rate. In some examples, the first down-sampling rate may be greater than the second down-sampling rate by a factor of $2^n$, where n is an integer.

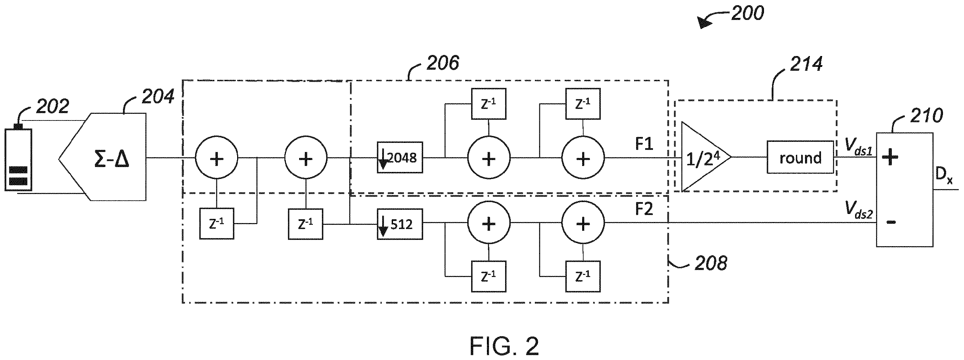

Figure 2 illustrates a second example monitoring circuit according to an embodiment of the present disclosure. Features of Figure 2 that also appear in Figure 1 have been given corresponding reference numbers in the 200 series and will not necessarily be described again here.

In this example, the sigma delta 204 comprises a first-order sigma delta clocked at a frequency of 2 MHz. The clock frequency corresponds to an OSR of 2048 relative to a desired frequency of 976.5 Hz of the first down-sampled cell voltage signal, $V_{ds1}$, (corresponding to the digital cell voltage measurement signal) at the output of the first decimation filter 206. The first decimation filter 206 has a first down-sampling rate equal to the OSR (2048). The second decimation filter 207 has a second down-sampling rate equal to a quarter of the first down-sampling rate, i.e. 512. As a result, the second down-sampled voltage signal, $V_{ds2}$, is at a frequency of 3.91 kHz. The second down-sampling rate may be selected based on a trade-off between quantization noise and bandwidth, to be able to catch the micro-short shape.

In this example, the first decimation filter 206 and the second decimation filter 208 each comprise second order cascaded integrator-comb (CIC) filters implemented using the known Hogenauer implementation. Other examples may utilise different known decimation filter implementations.

As the gain of the CICs of the first decimation filter 206 and the second decimation filter 208 is different, the monitoring circuit 200 further comprises a scaling circuit 214 for scaling the first down-sampled cell voltage signal, $V_{ds1}$, to have the same resolution / least significant bit (LSB) as the second down-sampled cell voltage signal, $V_{ds2}$. As a result, the difference module 210 can simply subtract the (scaled) first down-sampled cell voltage signal, $V_{ds1}$, from the second down-sampled cell voltage signal, $V_{ds2}$, or vice versa, to find the difference between the two signals.

In this example, the scaling circuit 214 comprises a digital divider circuit that divides the first down-sampled voltage signal, $V_{ds1}$, by 2 raised to the power of the ratio of the first down-sampling rate to the second down-sampling rate. The scaling circuit 214 further includes a digital rounding circuit to round any results according to the LSB of the scaled first down-sampled voltage signal, $V_{ds1}$. The scaling circuit 214 can scale the first down-sampled voltage signal, $V_{ds1}$, to output a scaled first down-sampled voltage signal, $V_{ds1}$. It will be appreciated that although Figure 2 illustrates the scaling circuit 214 as a separate circuit, in some examples the scaling circuit may form part of the first decimation filter 206 or the difference module 210.

In this example, the difference module 210 comprises a simple subtraction module that outputs the cell monitoring signal, $D_x$, as the difference between the (scaled) down-sampled cell voltage signal, $V_{ds1}$, and the second down-sampled cell voltage signal, $V_{ds2}$.

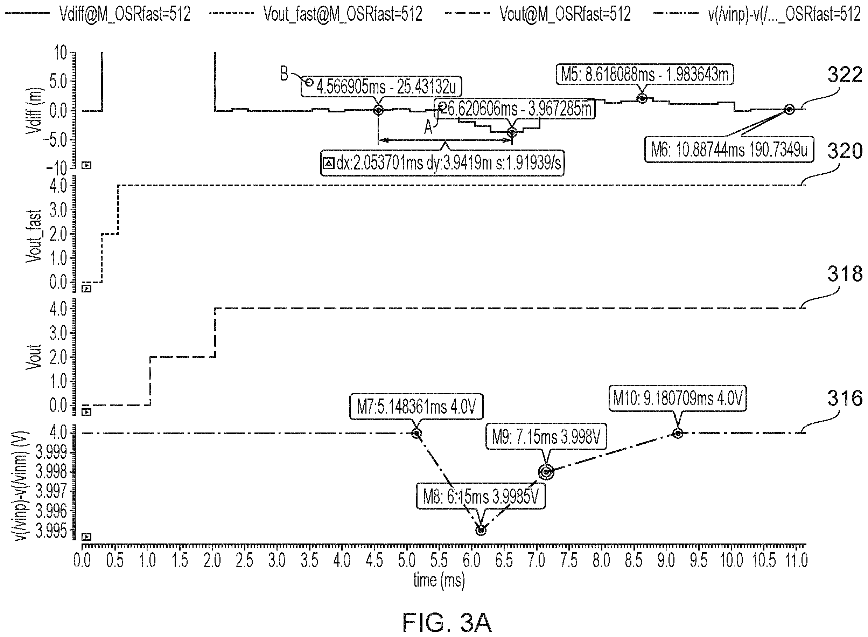

Figure 3A illustrates an example simulated cell monitoring signal of a monitoring circuit according to an embodiment of the present disclosure.

A first plot 316 illustrates an analog cell voltage signal including a current spike corresponding to a MSC. The amplitude of the spike is 5 mV on a 4 V signal.

A second plot 318 illustrates the first down-sampled cell voltage signal, $V_{ds1}$, corresponding to the analog cell voltage signal. The information relating to the spike has been averaged out by the down-sampling process.

A third plot 320 illustrates the second down-sampled cell voltage signal, $V_{ds2}$, corresponding to the analog cell voltage signal.

A fourth plot 322 illustrates the cell monitoring signal, $D_x$, equal to the difference between the first down-sampled cell voltage signal, $V_{ds1}$, and the second down-sampled cell voltage signal, $V_{ds2}$. The current spike information can be seen as a ripple on the the cell monitoring signal, $D_x$.

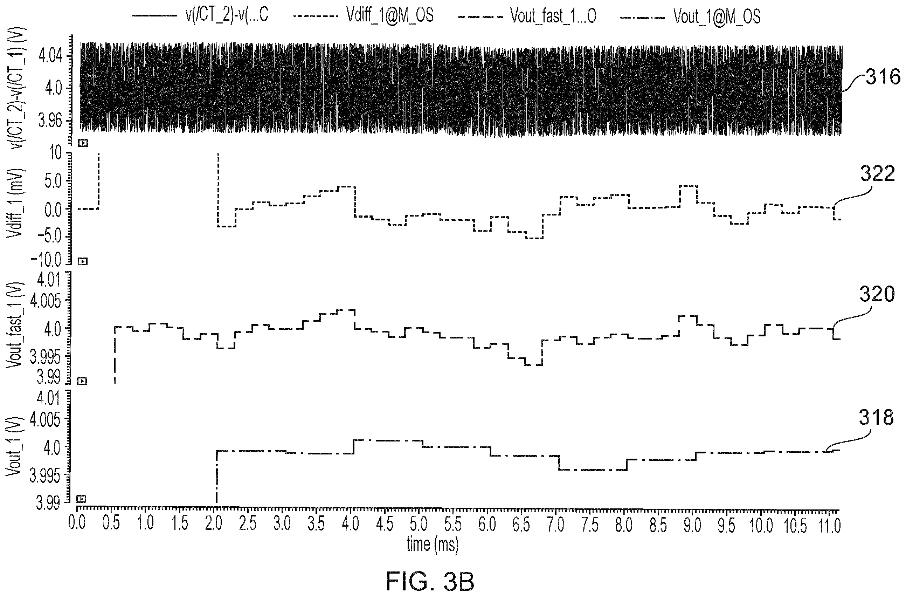

Figure 3B illustrates simulated noise effects on an example cell monitoring signal of a monitoring circuit according to an embodiment of the present disclosure. The same reference numbering has been used as used in Figure 3A.

In this example, noise that is present on the analog cell voltage 316 at least partially obscures the spike information in the second down-sampled cell voltage signal, $V_{ds2}$, 320 and the cell monitoring signal, $D_x$, 322. The simulated noise 322 comprises 3 x amplitude noise on a string of four battery cells.

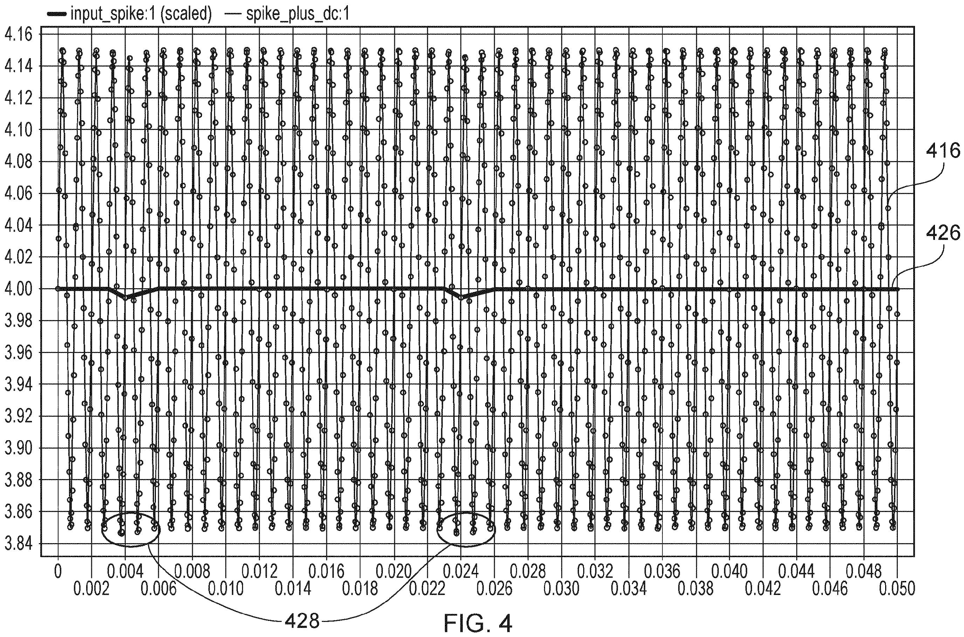

The noise effect is further schematically illustrated in Figure 4. In this example, a first plot 416 illustrates the cell voltage at a nominal value of 4V with 150 mV of noise interference. A second plot 426 illustrates (scaled) 5 mV current spikes. The current spikes result in a change in the maximum and minimum amplitude signals of the cell voltage 416 as illustrated by regions 428. Detecting this difference using a single cell monitoring signal, $D_x$, is possible but may require additional signal processing.

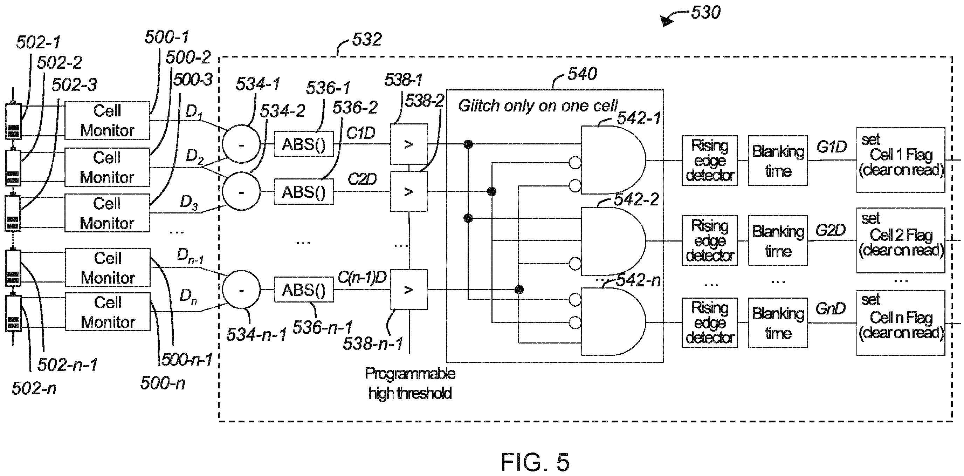

Figure 5 illustrates a monitoring system 530 for detecting a current spike arising from a MSC in one of a plurality (integer n in this example) of battery cells 502-1, 502-2, 502-3... 502-n-1, 502-n (referred to collectively as the plurality of battery cells 502) connected in series according to an embodiment of the present disclosure.

The monitoring system 530 comprises a plurality of monitoring circuits 500-1, 500-2, 500-3... 500-n-1, 500-n (referred to collectively as the plurality of monitoring circuits 500), each monitoring circuit corresponding to one of the plurality of battery cells 502 and configured to output a respective cell monitoring signal $D_1$, $D_2$, $D_3$... $D_{n-1}$, $D_n$ (referred to collectively as cell monitoring signals $D_x$).

The monitoring system 530 further comprises processing logic 532. The processing logic 532 is configured to detect a micro-short-circuit in one of the plurality of battery cells based on difference signals, $C1D$, $C2D...C(n-1)D$, (referred to collectively as difference signals $CxD$) corresponding to differences between the cell monitoring signals, $D_x$, of adjacent battery cells of the plurality of battery cells 502.

In detail, the processing logic 532 is configured to determine:

1. for each end battery cell 502-1, 502-n at an end of the series string of battery cells 502 (and having only one immediate neighbouring battery cell), a difference signal $C1D$, $C(n-1)D$, between: the cell monitoring signal $D_1$, $D_n$ corresponding to the end battery cell 502-1, 502-n; and the cell monitoring signal $D_2$, $D_{n-1}$, corresponding to a neighbouring battery cell 502-2, 502-n-1 immediately adjacent to the end battery cell 502-1, 502-n. In other words, the processing logic determines the two difference signals (one for each end battery cell 502-1, 502-n):

$$C1D = ABS(D_1 - D_2)$$

$$C(n-1)D = ABS(D_n - D_{n-1})$$

2. for each intermediate battery cell 502-2...502-n-1 not at the end of the series string (and having two immediate neighbouring battery cells), two difference signals $C2D...C(n-2)D$ between: the cell monitoring signal $D_2...D_{n-1}$ corresponding to the intermediate battery cell 502-2, 502-n-1; and the cell monitoring signal $D_1$, $D_n$, corresponding to each neighbouring battery cell 502-1, 502-n immediately adjacent to the intermediate battery cell 502-2, 502-n-1. In other words, the processing logic determines the following set of difference signals for the intermediate battery cells:

$$C2D = ABS(D_2 - D_3)$$

$$C3D = ABS(D_3 - D_4)$$

...

$$C(n-2)D = ABS(D_{n-2} - D_{n-1})$$

It will be appreciated that determining two difference signals for a particular intermediate cell will typically determine one of the difference signals for each adjacent cell and that duplication is not required when determining the difference signals for those adjacent cells.

Put yet another way, the processing logic 532 determines a difference signal, $C1D...C(n-1)D$, between the cell monitoring signals, $Dx$, of each neighbouring pair of battery cells 502.

In this example, the processing logic 532 includes a plurality of subtraction circuits 534-1, 534-2,...534-n-1, for determining the difference between the cell monitoring signals Dx of each pair of neighbouring cells 502. The plurality of subtraction circuits 534 each receive a respective pair of cell monitoring signals, $D_x$, $D_{x+1}$, and output a difference signal, $CxD$, corresponding to a difference between the respective pair of cell monitoring signals, $D_x$, $O_{x+1}$. For example, a first subtraction circuit 534-1 receives the pair of cell monitoring signals $D_1$, $D_2$ corresponding to the neighbouring battery cells 502-1 and 502-2, and outputs the difference signal $C1D$.

In this example, the processing logic 532 further comprises a plurality of absolute value circuits 536-1, 536-2, 536-n-2, each absolute value circuit 536 corresponding to a respective subtraction circuit 534. Each absolute value circuit 536 receives a respective difference signal from a respective subtraction circuit 534 and outputs the difference signal as a positive value difference signal $C1D$, $C2D...C(n-1)D$. The combination of each subtraction circuit 534 with the respective absolute value circuit 536 ensures that any current spikes in the difference signals $C1D$, $C2D...C(n-1)D$, all have the same sign (positive in this example, but could also be negative).

In this example, the processing logic 532 further comprises a plurality of comparators 538-1, 538-2,...538-n, wherein each comparator is configured to compare a respective difference signal CxD to a threshold value. The threshold value may comprise a programmable threshold. Providing a programmable threshold can allow for variability in noise requirements of different battery cell applications (e.g. how much noise comes from external components and how much frequency overlap is there --> harmonics of the HV system should not lead to false positives). In some examples, the there may be multiple threshold values, for example a high threshold value and a low threshold value. Each comparator 538 may receive a respective difference signal, $CxD$, and output a logic signal representative of whether the difference signal, $CxD$, exceeds the threshold value (indicative of a spike). For example, each comparator 538 may output a logic high signal (logic value of ONE) if an amplitude of the difference signal, *CxD,* exceeds the threshold value and output a logic low signal (logic value of ZERO) if the amplitude of the difference signal, *CxD,* is less than or equal to the threshold value.

In this example, the processing logic 532 further comprises a cell identifier module 540. The cell identifier module 540 can identify a particular battery cell that experiences a MSC based on the logic signals from the plurality of comparators. The cell identifier module 540 includes a plurality of AND gates 542-1, 542-2, 542-n, each corresponding to a respective battery cell 502. Each AND gate 542 receives each of the plurality of logic signals. Each AND gate 542 receives: (i) the logic signals associated with the battery cell 502 corresponding to the AND gate; and (ii) inverted versions of the remaining logic signals. In this way, an AND gate 542 will indicate that its corresponding battery cell 502 has experienced a MSC if: (i) each difference signal, *CxD,* associated with that battery cell 502 is greater than the threshold value (corresponding logic signal is ONE); and (ii) each remaining difference cell, *CxD,* is less than or equal to the threshold value (corresponding logic cell is ZERO which is inverted to ONE). Each AND gate outputs a respective cell flag signal, *G1D, G2D,...GnD,* representative of whether the corresponding battery cell has experienced a MSC. In this example, the processing logic 532 includes further processing modules for processing the plurality of cell flag signals, including a respective plurality of rising edge detectors, a plurality of blanking time modules and a plurality of flag registers.

Generally, the processing logic 532 is configured to: compare each difference signal to a threshold value; and detect a micro-short-circuit in one of the plurality of battery cells if: (i) each difference signal associated with that battery cell exceed the threshold value; and (ii) the remaining difference signals do not exceed the threshold value. Here, difference signals associated with a battery cell comprise each difference signal determined based on a difference between the cell monitoring signal corresponding to that battery cell and a cell monitoring signal corresponding to an adjacent battery cell.

The monitoring system 500 can advantageously isolate a voltage peak representative of a current spike from a MSC from any noise obscuring the signals, such as that illustrated in Figures 3B and 4. The plurality of battery cells 502 connected in series and their respective cell monitoring signals, $D_x$, will each be exposed to substantially the same noise signal. This noise signal is effectively cancelled when the processing logic 532 determines the difference signals, CxD, as the difference between pairs of cell monitoring signals, $D_x$, $D_{x+1}$, from adjacent battery cells 502 because the cell monitoring signals, $D_x$, $D_{x+1}$, have substantially the same noise profile.

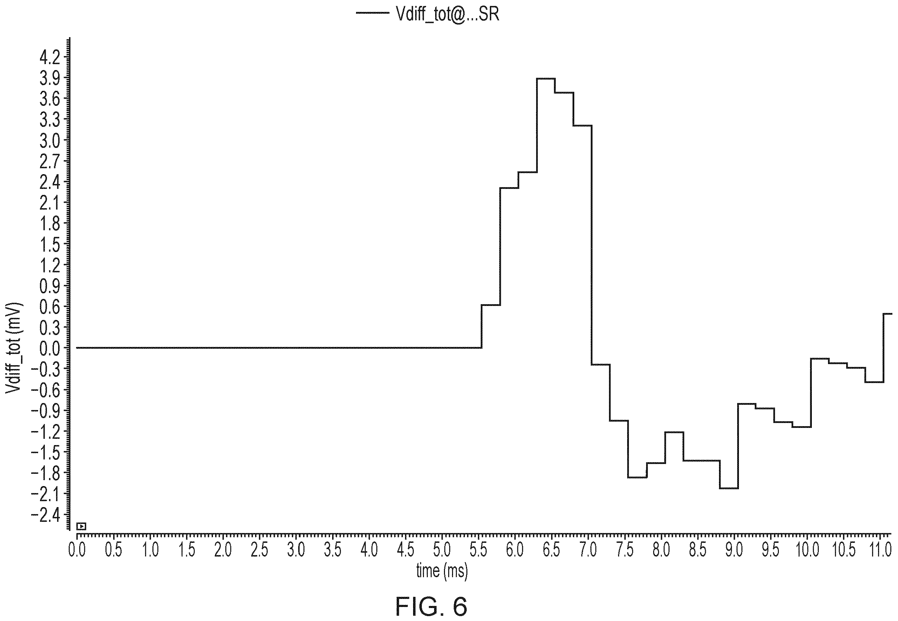

Figure 6 illustrates a simulated difference signal, *CxD,* calculated as the difference between two noisy cell monitoring signals, $D_x$, $D_{x+1}$, corresponding to an adjacent pair of battery cells, such as the noisy cell monitoring signal 322 of Figure 3B. An MSC spike is clearly visible as an oscillation about 0V.

The cell monitoring circuits and/or the monitoring systems of the present disclosure can output the respective cell monitoring signal and cell flag signal to provide a binary indication of whether a particular battery cell has experienced a MSC. The cell monitoring signal / cell flag signal is indicative of an identification of the battery cell that experienced the spike which enables the BMU to determine a MSC occurrence interval for each battery cell.

However, due to the non-binary nature of the cell monitoring signal and the difference signals, the cell monitoring circuits and/or the monitoring systems can also generate a number of additional results and output signals for the BMU. The additional results may include one or more of:

    1. An amplitude of the last detected spike
    2. A maximum amplitude over time for the detected spikes
    3. A time duration of the last detected spike
    4. A maximum time duration over time for the detected spikes
    5. The number of detected spikes over time with an overflow flag.

The monitoring system may comprise one or more parameter registers for storing a parameter state of a respective parameter result. Each of the additional parameter results can be determined across all cells (1 register for all cells) and/or for each individual cell (1 register for each cell).

The additional parameters can be determined from the cell monitoring signal (if the noise is sufficiently low or reduced) and/or the difference signals. The processing logic of the cell monitoring circuit/ monitoring system may contain the relevant functionality to obtain the identified parameters. The one or more additional results can advantageously be output by the cell monitoring circuit / monitoring system to the BMU for predictive maintenance features.

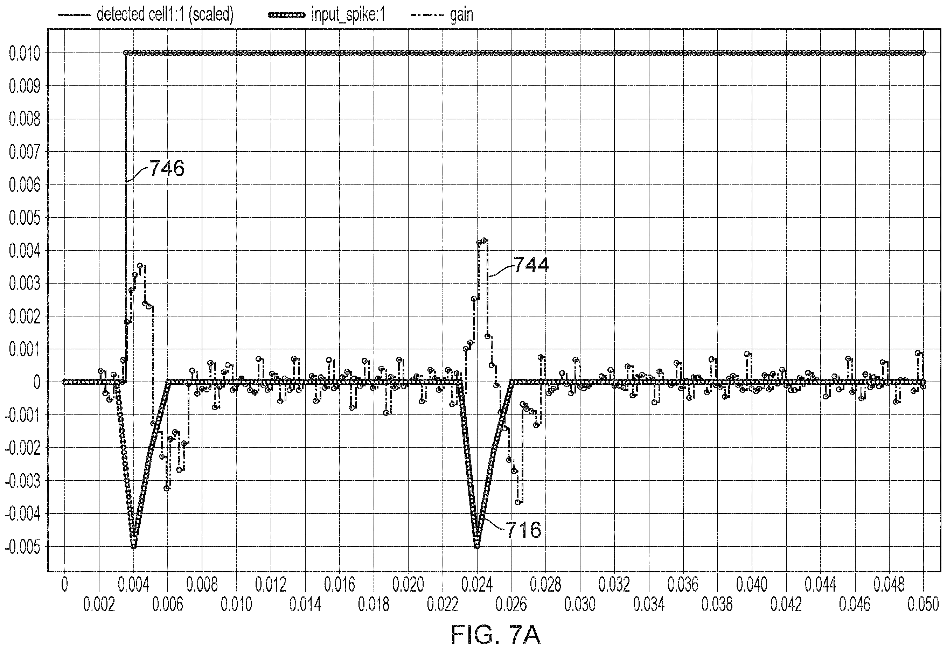

Figures 7A to 7D illustrate various output signals of a cell monitoring system according to an embodiment of the present disclosure. Reference is made to the arrangement of Figure 5. The processing logic may contain additional known logic components to derive the signals of Figures 7A to 7D which is not discussed here.

Figure 7A illustrates two simulated spikes in the analog cell voltage 716 of the first battery cell 502 and the resulting response of the first difference signal, *C1D,* 744 equal to a difference between the first cell monitoring signal, $D_1$, corresponding to the first battery cell 502-1 and the second cell monitoring signal, $D_2$, corresponding the second battery cell 502-2. The two spikes are clearly detectable in the first difference signal, C1D. As there are no spikes in the other battery cells, 502-2...502-n, the remaining difference signals stay below the threshold value and the monitoring system detects a MSC in the first battery cell 502. The first cell flag signal, $G1D$, 746 goes high at the time of the first spike. In this example, the monitoring system has a 100ms measurement period (before the first cell flag signal resets) so the first cell flag signal 746 remains high for the rest of the plot.

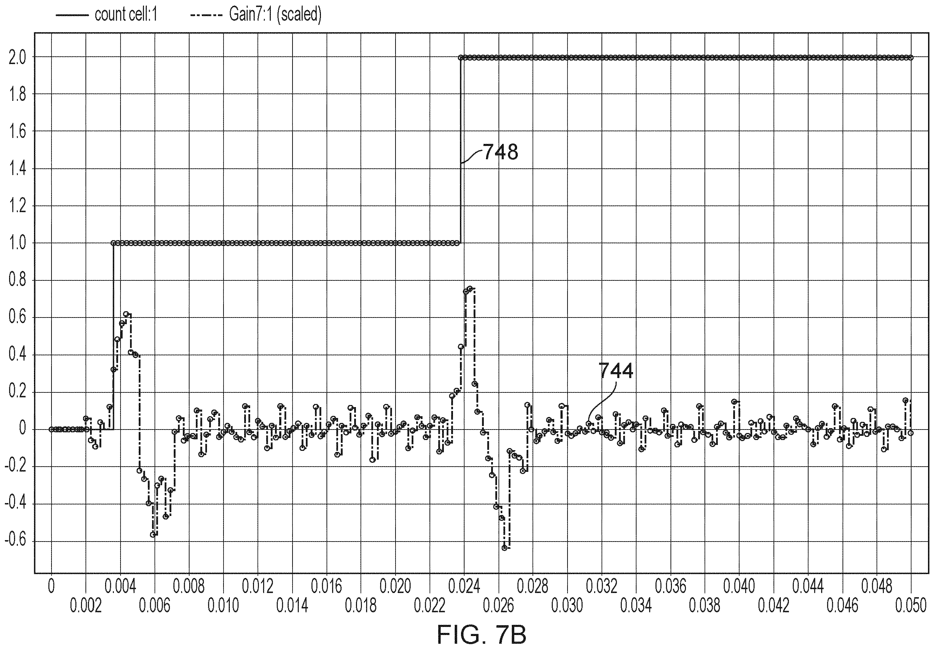

Figure 7B illustrates a counter signal 748 to count the number of spike / MSC events for a particular battery cell (the first battery cell 502-1 in this example). The counter signal 748 increases in value for each detected spike (greater than the threshold value) in the difference signal 744. In other examples, a counter signal may count a total number of spikes / MSC events across all battery cells 502.

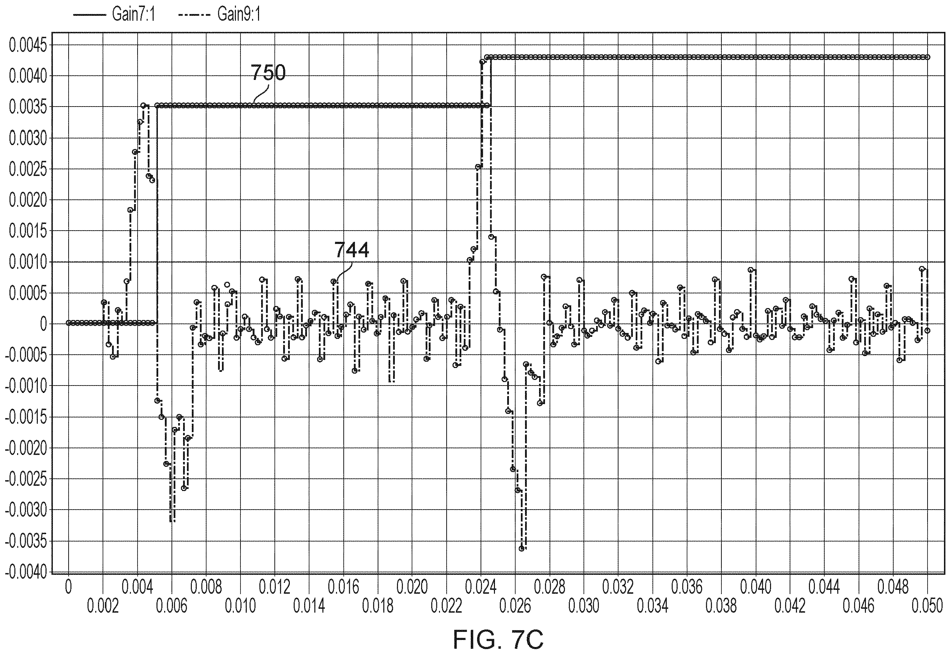

Figure 7C illustrates an amplitude of last detected spike signal 750 that tracks an amplitude of the most recent spike event for a particular battery cell (the first battery cell 502-1 in this example). The maximum amplitude signal 750 increases to a first value that matches the maximum amplitude of the first spike in the first difference signal 744 and then increases to match the higher maximum amplitude of the second spike in the first difference signal 744.

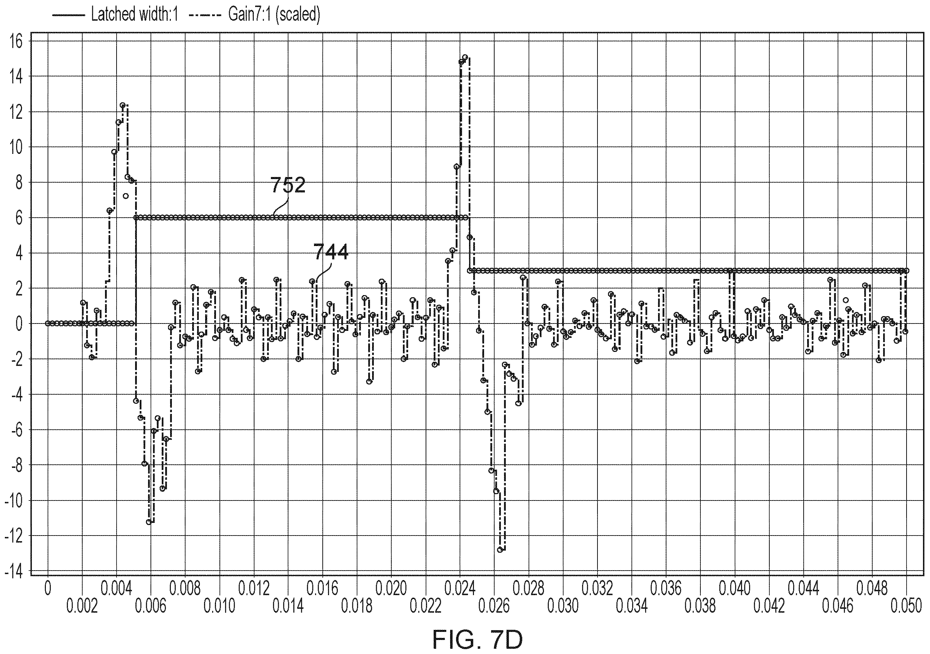

Figure 7D illustrates a duration of last detected spike signal 752 that tracks a duration of the most recent spike event for a particular battery cell (the first battery cell 502-1 in this example). The last detected spike signal 752 increases to a first value that matches the duration of the first spike in the first difference signal 744 and then decreases to match the shorter duration of the second spike in the first difference signal 744.

The circuits and systems of the present disclosure may output one or more of these parameter output signals to the BMU to enable predictive maintenance of each battery cell of the plurality of battery cells. The CMC may also compare cell data to allow for predictive maintenance features.

The circuits and systems of the present disclosure provide a lightweight hardware implementation for MSC detection and cell health monitoring. The circuits and systems can provide faster and more stable MSC detection with less effort in accuracy and communication speed on the overall BMS system. As the disclosed circuits and systems can provide an MSC data stream (cell monitoring signal, cell flag signal and parameter output signals) in parallel to the voltage data stream (first down-sampled cell voltage signal) from the CMC to the BMU, the communication of data over the bus frequency can be reduced, since the frequency is not needed any longer for fast software based cell failure (MSC) detection and SoX can be based on 1Hz (instead of 10Hz+).

The disclosed circuits and systems provide a battery cell state of health sensor based on analog signal statistics for real world MSC pulse shapes into the A/D convertor without an additional chip, infrastructure on the circuit board or software solutions in the BMU. The disclosed circuits and systems can be highly accurate even in noise or EMI situations when noise is 3x the amplitude of the spike voltage to be detected, because it is on the CMC "close" to the cell. The disclosed circuits and systems can replace software based "cell wear detection" and "thermal runaway detection" mechanisms in a BMS improving safety. The disclosed circuits and systems can also be used in cell formation and test devices during production and validation of cells in order to earlier identify cells that will have lifetime issues / defects.

The circuits and systems of the present disclosure can improve functional safety aspects of the BMS by using dual components and cross comparisons on cells to detect cell failure. As noted above, one of the DEC filters can act as the cell measurement channel while the other DEC filter provides for a functional safety implementation at the CMC level. As noted above, requirements for high-speed critical safety software can be reduced with the present disclosure. In addition, injection of safety checks can be easier as the channels in front of the ADCs can be switched. The disclosed functional implementation also allows for "function under failure" for certain components. There is also the possibility to design different layouts on ADC primary / secondary or double use and pinning.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more nontransient machine or computer-readable or computerusable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A monitoring circuit for a battery cell, the monitoring circuit comprising:

   a sigma-delta modulator configured to receive an analog cell voltage signal and output a digital cell voltage signal;
   a first decimation filter configured to receive the digital cell voltage signal and down-sample the digital cell voltage signal at a first down-sampling rate to output a first down-sampled cell voltage signal;
   a second decimation filter configured to receive the digital cell voltage signal and down-sample the digital cell voltage signal at a second down-sampling rate, different to the first down-sampling rate, to output a second down-sampled cell voltage signal; and
   a difference module configured to receive the first down-sampled cell voltage signal and the second down-sampled cell voltage signal and output a cell monitoring signal based on a difference between the first down-sampled cell voltage signal and the second down-sampled cell voltage signal.

2. The monitoring circuit of claim 1, wherein the second down-sampling rate is less than the first down-sampling rate.

3. The monitoring circuit of claim 2, wherein the first down-sampling rate is equal to an oversampling rate of the sigma-delta modulator.

4. The monitoring circuit of claim 1 or claim 2, wherein the monitoring circuit comprises a scaling circuit configured to scale the first down-sampled cell voltage to have the same resolution as the second down-sampled cell voltage.

5. The monitoring circuit of any preceding claim, wherein the monitoring circuit is configured to detect a micro-short-circuit in the battery cell if an amplitude of the cell monitoring signal exceeds a threshold value.

6. The monitoring circuit of any of claims 1 to 5, wherein the sigma delta modulator and the first decimator form an analog to digital conversion circuit and the monitoring circuit is configured to output the first down-sampled-cell-voltage signal to a battery management system for voltage measurement.

7. A monitoring system for a plurality of battery cells connected in series, the monitoring system comprising:

   a plurality of monitoring circuits according to any preceding claim, each monitoring circuit corresponding to one of the plurality of battery cells and configured to output a respective cell monitoring signal;
   processing logic configured to detect a micro-short-circuit in one of the plurality of battery cells based on difference signals corresponding to differences between the cell monitoring signals of adjacent battery cells of the plurality of battery cells.

8. The monitoring system of claim 7, wherein the processing logic is configured to determine a difference signal between the respective cell monitoring signals of each neighbouring pair of battery cells of the plurality of battery cells.

9. The monitoring system of claim 7 or claim 8, wherein the processing logic is configured to:

   compare an amplitude of each difference signal to a threshold value; and
   detect a micro-short-circuit in one of the plurality of battery cells if the amplitude of each difference signal associated with that battery cell exceeds the threshold value.

10. The monitoring system of claim 9, wherein the processing logic is configured to detect a micro-short-circuit in one of the plurality of battery cells if:

the amplitude of each difference signal associated with that battery cell exceed the threshold value; and
the amplitude of each of the remaining difference signals does not exceed the threshold value.

11. The monitoring system of claim 9 or claim 10, wherein the processing logic comprises a plurality of comparators, wherein each comparator is configured to receive a respective difference signal, compare an amplitude of the difference signal against the threshold value and output a logic signal representative of whether the amplitude of the difference signal exceeds the threshold value.

12. The monitoring system of claim 11, wherein the processing logic comprises a plurality of AND gates, wherein each AND gate corresponds to a respective battery cell and each AND gate is configured to receive:

each logic signal associated with the respective battery cell;
inverted versions of each remaining logic signal.

13. The monitoring system of any of claims 7 to 12, wherein the processing logic is configured to output one or more parameter output signals comprising one or more of:

a cell flag signal indicating detection of a spike corresponding to a micro-short-circuit, for each battery cell.
an amplitude of a last detected spike, for all battery cells and/or for each battery cell;
a maximum amplitude over time of the detected spikes, for all battery cells and/or for each battery cell;
a time duration of the last detected spike, for all battery cells and/or for each battery cell;
a maximum time duration over time of the detected spikes, for all battery cells and/or for each battery cell; and
a total number of detected spikes over time, for all battery cells and/or for each battery cell.

14. A battery management system comprising the battery monitoring circuit of any of claims 1 to 6 or the monitoring system of claims 7 to 13.

15. The battery management system of claim 14, comprising the monitoring system of claim 13, wherein the battery management system is configured to determine one or more of:

a cell state of each of the plurality of battery cells based on the one or more parameter output signals; and
a functional safety state of the battery management system based on the one or more parameter output signals.

FIG. 1

FIG. 2

FIG. 3A

FIG. 3B

FIG. 4

FIG. 5

FIG. 6

EP 4 632 411 A1

FIG. 7A

FIG. 7B

EP 4 632 411 A1

FIG. 7C

FIG. 7D

Europäisches
Patentamt

European
Patent Office

Office européen
des brevets

# EUROPEAN SEARCH REPORT

**Application Number**

EP 24 30 5592

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2023/119967 A1 (MURATA MANUFACTURING CO [JP]) 29 June 2023 (2023-06-29)<br>* paragraph [0023] - paragraph [0066] *<br>----- | 1-15 | INV.<br>G01R31/392<br>G01R31/396 |
| A | US 2017/082693 A1 (LEIDICH STEFAN [DE] ET AL) 23 March 2017 (2017-03-23)<br>* paragraph [0054] - paragraph [0079] *<br>----- | 1-15 | |
| A | US 2019/219640 A1 (LIU BINGXIAO [CN] ET AL) 18 July 2019 (2019-07-18)<br>* paragraph [0128] - paragraph [0216] *<br>----- | 1-15 | |
| A | HOGREFE CHRISTIN ET AL: "Direct observation of internal short circuits by lithium dendrites in cross-sectional lithium-ion in situ full cells", JOURNAL OF POWER SOURCES, ELSEVIER, AMSTERDAM, NL, vol. 556, 2 December 2022 (2022-12-02), XP087235806, ISSN: 0378-7753, DOI: 10.1016/J.JPOWSOUR.2022.232391 [retrieved on 2022-12-02]<br>* the whole document *<br>----- | 1-15 | **TECHNICAL FIELDS SEARCHED (IPC)**<br><br>G01R |

The present search report has been drawn up for all claims

| Place of search | Date of completion of the search | Examiner |
|---|---|---|
| Munich | 23 September 2024 | Meggyesi, Zoltán |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 30 5592

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2024

| Patent document cited in search report | Publication date | Patent family member(s) | | Publication date |
|---|---|---|---|---|
| WO 2023119967 A1 | 29-06-2023 | NONE | | |
| US 2017082693 A1 | 23-03-2017 | CN | 106104285 A | 09-11-2016 |
| | | DE | 102014204956 A1 | 24-09-2015 |
| | | US | 2017082693 A1 | 23-03-2017 |
| | | WO | 2015139927 A1 | 24-09-2015 |
| US 2019219640 A1 | 18-07-2019 | CN | 107870301 A | 03-04-2018 |
| | | DK | 3832328 T3 | 28-03-2022 |
| | | EP | 3508867 A1 | 10-07-2019 |
| | | EP | 3832328 A1 | 09-06-2021 |
| | | US | 2019219640 A1 | 18-07-2019 |
| | | WO | 2018059074 A1 | 05-04-2018 |

EPO FORM P0459

For more details about this annex : see Official Journal of the European Patent Office, No. 12/82